# FASCICULE DE BREVET EUROPEEN

(11) **EP 2 591 327 B1**
(45) Date de publication et mention de la délivrance du brevet: **13.12.2017**
(21) Numéro de dépôt: 11729317.5
(22) Date de dépôt: 06.07.2011
(51) Int. Cl.: G01K 17/00, G01J 5/12, H01L 35/32

(54) **DISPOSITIF POUR LA MESURE D'UN FLUX THERMIQUE ET SON PROCÉDÉ DE FABRICATION**
VORRICHTUNG ZUR MESSUNG EINES WÄRMESTROMS UND HERSTELLUNGSVERFAHREN DAFÜR
DEVICE FOR MEASURING A HEAT FLUX AND MANUFACTURING METHOD THEREOF

(30) Priorité: 06.07.2010 FR 1055463
(43) Date de publication de la demande: 15.05.2013
(73) Titulaire: Université du Maine, 72085 Le Mans Cedex 9 (FR)
(72) Inventeur: CAMBERLEIN, Lionel, F-72000 Le Mans (FR); GAVIOT, Etienne, F-72000 Le Mans (FR); POLET, Frédéric, F-72000 Le Mans (FR); BECHE, Bruno, F-35000 Rennes (FR); FAILLEAU, Guillaume, F-72190 Le Mans (FR); RONAN, Morice, F-92370 Chaville (FR); LE SANT, Véronique, F-78320 Le Mesnil Saint Denis (FR)
(74) Mandataire: Le Guen-Maillet
(86) Numéro de dépôt international: PCT/EP2011/061371
(87) Numéro de publication internationale: WO 2012/004286

(56) Documents cités:
- EP-A1- 1 767 913
- FR-A1- 2 704 979
- FR-A1- 2 781 931
- LOBACH O V ET AL: "Features of semiconductor fluxmeters", ELECTRON DEVICES AND MATERIALS, 2003. PROCEEDINGS. 4TH ANNUAL 2003 SIB ERIAN RUSSIAN WORKSHOP ON JULY 1-4, 2003, PISCATAWAY, NJ, USA,IEEE, 1 juillet 2003 (2003-07-01), pages 78-80, XP010654370, ISBN: 978-5-7782-0412-6

## Description

La présente invention concerne un dispositif de mesure de flux thermique.

Les dispositifs de mesure de flux thermique sont basés sur l'utilisation de thermopiles. Une thermopile est un composant électronique qui convertit une énergie thermique en énergie électrique. Une thermopile est par exemple constituée de thermocouples ou cellules qui sont généralement connectés en série. Une cellule est constituée de deux métaux ou alliages de natures différentes, par exemple de cuivre et constantan ou Nickel et Chromel®. Les métaux ou alliages sont reliés par deux thermojonctions. Chaque cellule comporte une zone refroidie à une première thermojonction et une zone réchauffée à une seconde thermojonction. Par effet Seebeck, le thermocouple génère une différence de potentiel qui dépend de la différence de température entre les thermojonctions.

Il est à remarquer ici qu'un thermocouple ne mesure pas une température, mais une différence de température.

Le brevet FR 2781931 divulgue une thermopile qui comporte une pluralité de thermojonctions, du type distribuées, réalisées sur un substrat de silicium. Le substrat comporte une pluralité de zones de discontinuités thermiques qui présentent une conductivité thermique strictement inférieure à la conductivité thermique du substrat. Les zones de discontinuité thermique sont localisées respectivement au droit d'une jonction sur deux.

Ce type de thermopile n'est pas adapté à des mesures de flux thermique à des hautes températures telles que 1000°C. Un autre fluxmètre est décrit dans "Features of Semiconductor Fluxmeters" par Oleg V. Lobach et al., pages 78-80, dans le 4th Siberian Russion Workshop and Toturials EDM'2003, Section I. La présente invention a pour but de résoudre les inconvénients de l'art antérieur en proposant un dispositif pour la mesure d'un flux thermique qui soit adapté à des mesures de flux thermique à des hautes températures telles que 1000°C et qui soit de bonne sensibilité.

A cette fin, selon un premier aspect, l'invention propose un dispositif pour la mesure d'un flux thermique, comportant une thermopile constituée d'une pluralité de thermojonctions de type distribuées, caractérisé en ce que le dispositif est constitué d'un premier et un second substrats en céramique, une première face du premier substrat est composée de cavités séparées par des cales de céramique, la thermopile est placée sur la face plane du premier substrat opposée à la première face, les cales du premier substrat sont disposées sous une thermojonction sur deux de la thermopile, une première face du second substrat est composée de cavités séparées par des cales de céramique, une seconde face du second substrat étant plane, la première face du second substrat composée des cavités et de cales reposant sur les thermojonctions de telle sorte que les cales du second substrat reposent sur une thermojonction sous laquelle une cale du premier substrat n'est pas disposée.

Ainsi, en disposant les cales des premier et second substrats de cette manière, les lignes de flux thermique sont concentrées au niveau des cales du second substrat dont les contacts inférieurs imposent à l'ensemble de la chaleur de transiter vers les thermojonctions chaudes de la thermopile et de transiter vers les cales Ca1 à Ca4.

Cette duplication des cales pour les substrats en céramique diminue la conductivité thermique du dispositif pour la mesure d'un flux thermique et améliore grandement la sensibilité du dispositif pour la mesure d'un flux thermique.

Cet ensemble de substrats permet une déflexion optimale des lignes de chaleur traversant le dispositif de mesure de flux thermique et permet d'obtenir une pluralité de gradients thermiques tangentiels à la thermopile, c'est-à-dire dans un plan perpendiculaire aux lignes de chaleur traversant le dispositif de mesure de flux thermique.

Selon un mode particulier de l'invention, la céramique a une conductivité thermique comprise entre 0,5 à 15 W/m.K.

Ainsi, une conductivité thermique comprise entre 0,5 à 15 W/m.K permet d'obtenir différents compromis en terme de sensibilité, temps de réponse et résistance thermique globale de transfert.

Selon un mode particulier de l'invention, la céramique a une conductivité thermique de 1,46 W/m.K.

Ainsi, une conductivité thermique de 1,46 W/m.K est un compromis en terme de sensibilité, temps de réponse et résistance thermique globale de transfert.

Selon un mode particulier de l'invention, les cavités et les cales sont obtenues par usinage des substrats.

Ainsi, l'opération est effectuée automatiquement et avec une machine peu onéreuse. L'opération d'usinage remplace avantageusement une opération telle que par exemple, une gravure sèche à flancs droits de micro technologie par RIE (reactive ionic etching). Ce type de gravure est long et très coûteux.

Selon un mode particulier de l'invention, les premier et second substrats sont collés l'un à l'autre par l'intermédiaire des cales du second substrat, de la face du second substrat composée de cavités séparées, par des cales de céramique, de la seconde face du premier substrat et de la thermopile.

Ainsi, la fabrication d'un dispositif de mesure de flux thermique est décomposée en opérations simples qui ne demandent pas d'appareillages complexes.

Selon un mode particulier de l'invention, la thermopile est constituée d'une bande continue composée alternativement de dépôts d'un premier et d'un second métaux ou alliages de caractéristiques thermoélectriques différentes, la bande continue est méandriforme et repliée pour former un quadrilatère et chaque dépôt de métal ou d'alliage d'un méandre juxtapose un dépôt de métal ou d'alliage différent d'un autre méandre.

Ainsi, le caractère continu de la bande du premier conducteur permet d'éviter une rupture du circuit électrique en cas de défaut de placage par le second dépôt de métal ou d'alliage tel que par exemple une craquelure de dilatation ou une fissuration mécanique.

En outre, la disposition des dépôts en damier permet à l'usinage des substrats d'être effectué simplement en tranchées parallèles.

Selon un mode particulier de l'invention, les métaux ou alliages ont des conductivités électriques différentes, les dépôts du métal ou de l'alliage ayant la plus grande conductivité électrique sont effectués sur des dépôts du métal ou de l'alliage ayant la plus faible conductivité électrique, les dépôts du métal ou de l'alliage ayant la plus grande conductivité électrique et les dépôts du métal ou de l'alliage ayant la plus faible conductivité électrique sur lesquels sont effectués les dépôts du métal ou de l'alliage ayant la plus grande conductivité électrique ont à leurs extrémités une largeur égale à la largeur des dépôts du métal ou de l'alliage ayant la plus faible conductivité électrique et sur lesquels aucun dépôt de métal ou de l'alliage, ayant la plus grande conductivité électrique n'est effectué et ont en leur partie intermédiaire une largeur inférieure à la largeur des dépôts du métal ou de l'alliage ayant la plus faible conductivité électrique et sur lesquels aucun dépôt de métal ou de l'alliage ayant la plus grande conductivité électrique n'est effectué.

Ainsi, la disposition de deux métaux ou alliages avec le plus conducteur au dessus permet de bénéficier d'un coefficient relatif équivalent de Seebeck de valeur optimale.

De même, le rapport signal/bruit du dispositif de mesure de flux thermique est optimisé.

Selon un mode particulier de l'invention, la thermopile comporte une première et une seconde bornes de contacts, chaque borne de contact étant apte à être reliée électriquement à un fil, et le second substrat est usiné dans chaque partie en regard avec une borne de contact de manière à permettre un enroulement du fil autour d'un plot disposé au centre de la partie usinée.

Ainsi, l'enroulement du fil autour du plot permet de réaliser des bornes de contacts particulièrement robustes vis-à-vis des tractions continues, des dilatations et des vibrations mécaniques.

Corrélativement, la présente invention concerne un procédé de fabrication d'un dispositif pour la mesure d'un flux thermique, comportant une thermopile constituée d'une pluralité de thermojonctions de type distribuées, caractérisé en ce que le procédé comporte les étapes de :
- usinage d'un premier substrat de céramique sur une première face pour obtenir des cavités séparées par des cales de céramique,
- dépôt de la thermopile sur la seconde face plane du premier substrat, les cales du premier substrat étant disposées sous une thermojonction sur deux de la thermopile,
- usinage d'un second substrat de céramique sur une face pour obtenir des cavités séparées par des cales de céramique,
- collage de la face usinée du second substrat sur la face du premier substrat comportant la thermopile de telle manière que les cales du second substrat reposent sur une thermojonction sous laquelle une cale du premier substrat n'est pas disposée.

Ainsi, en disposant les cales des premier et second substrats de cette manière, les lignes de flux thermique sont concentrées au niveau des cales du second substrat dont les contacts inférieurs imposent à l'ensemble de la chaleur de transiter vers les thermojonctions chaudes de la thermopile et de transiter vers les cales Ca1 à Ca4.

Cette duplication des cales pour les substrats en céramique diminue la conductivité thermique du dispositif pour la mesure d'un flux thermique et améliore grandement la sensibilité du dispositif pour la mesure d'un flux thermique.

Cet ensemble de substrats permet une déflexion optimale des lignes de chaleur traversant le dispositif de mesure de flux thermique et permet d'obtenir une pluralité de gradients thermiques tangentiels à la thermopile, c'est-à-dire dans un plan perpendiculaire aux lignes de chaleur traversant le dispositif de mesure de flux thermique.

De plus, la fabrication d'un dispositif de mesure de flux thermique est décomposée en opérations simples qui ne demandent pas d'appareillages complexes.

Selon un mode particulier de l'invention, le procédé comporte en outre une étape de polissage de la seconde face plane du premier substrat préalablement au dépôt de la thermopile.

Ainsi, il est possible d'utiliser des céramiques usinables qui ne sont pas destinées à des applications de type microélectronique lors de leur commercialisation.

Selon un mode particulier de l'invention, la thermopile comporte une première et une seconde bornes de contacts, chaque borne de contact étant apte à être reliée électriquement à un fil, et le procédé comporte en outre l'étape d'usinage du second substrat dans chaque partie en regard avec une borne de contact de manière à permettre un enroulement du fil autour d'un plot disposé au centre de la partie usinée.

Selon un mode particulier de l'invention, le procédé comporte en outre les étapes de :
- enroulement de chaque fil autour du plot,
- collage de chaque fil au second substrat à l'aide d'une colle conductrice,
- établissement d'une liaison électrique entre chaque fil collé et une borne de contact à l'aide d'une colle conductrice.

Ainsi, l'enroulement du fil autour du plot permet de réaliser des bornes de contacts particulièrement robustes vis-à-vis des tractions continues, des dilatations et des vibrations mécaniques.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
la Fig. 1 représente deux substrats qui constituent le dispositif pour la mesure d'un flux thermique selon la présente invention ;
la Fig. 2 représente le dispositif pour la mesure d'un flux thermique selon la présente invention ainsi que la déflexion du flux thermique obtenue selon la présente invention ;
la Fig. 3 représente une représentation schématique du premier substrat et de la thermopile ;
la Fig. 4 est un mode particulier de la géométrie des dépôts de métaux ou d'alliages ;
la Fig. 5 est une vue schématique de l'usinage du second substrat dans chaque partie en regard avec une borne de contact de la thermopile ainsi que du placement du fil dans la partie usinée ;
la Fig. 6 est une coupe de l'usinage du second substrat dans une partie en regard avec une borne de contact de la thermopile ainsi que du placement du fil dans la partie usinée ;
la Fig. 7 est une coupe de l'usinage du second substrat dans une partie en regard avec une borne de contact de la thermopile ainsi que du collage du fil dans la partie usinée ;
la Fig. 8 est une coupe de l'usinage du second substrat dans une partie en regard avec une borne de contact de la thermopile ainsi que de l'établissement de la liaison électrique entre le fil collé dans la partie usinée avec une borne de contact de la thermopile;
la Fig. 9 est un exemple d'algorithme de fabrication d'un dispositif pour la mesure d'un flux thermique selon la présente invention ;
la Fig. 10 est un exemple d'algorithme de placement de connectique pour un dispositif pour la mesure d'un flux thermique selon la présente invention.

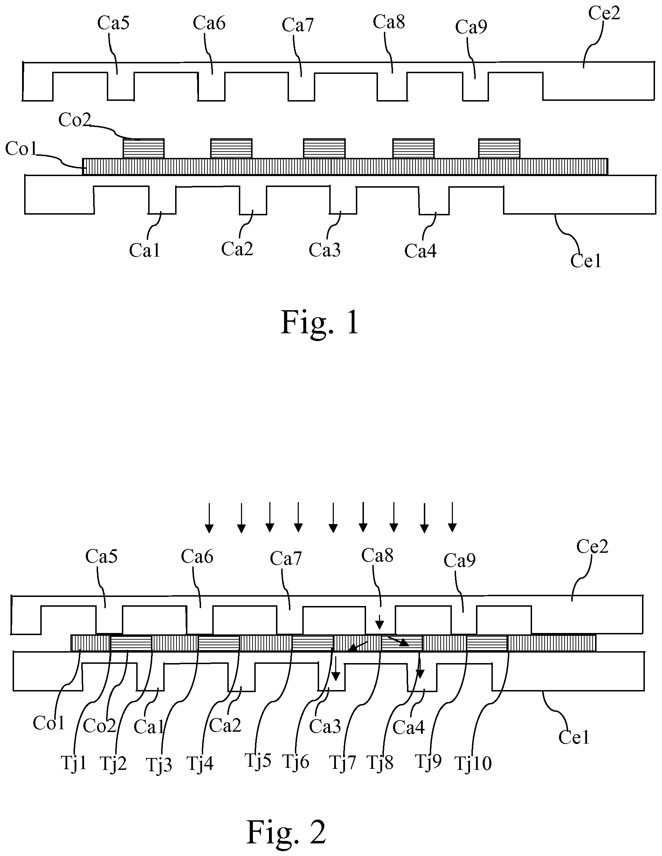

La **Fig. 1** représente deux substrats qui constituent le dispositif pour la mesure d'un flux thermique selon la présente invention.

Selon la présente invention, les deux substrats Ce1 et Ce2 qui constituent le dispositif pour la mesure d'un flux thermique sont des substrats en céramique.

Le substrat Ce1 a une face composée de cavités séparées par des cales de céramique Ca1 à Ca4.

Le substrat Ce2 a une face composée de cavités séparées par des cales de céramique Ca5 à Ca9.

Selon un mode particulier de réalisation de la présente invention, chaque face composée de cavités séparées par des cales de céramique est obtenue par usinage dudit substrat, plus précisément par fraisage dudit substrat.

Les substrats en céramique usinable sont par exemple réalisés dans un matériau de céramique usinable fourni sous la dénomination commerciale MACOR® par la société CORNING®.

La céramique utilisée selon la présente invention a une conductivité thermique comprise entre 0,5 à 15 W/m.K.

La conductivité thermique de la céramique permet de définir le temps de réponse, la précision, l'aptitude à mesurer un état adiabatique du dispositif pour la mesure d'un flux thermique.

A titre d'exemple et de manière non limitative, la céramique a une conductivité thermique de 1,46 W/m.K.

Lorsque le premier substrat est en céramique usinable MACOR®, l'autre face de la céramique doit être polie de manière à obtenir une surface dont la granularité est compatible avec l'épaisseur des métaux ou d'alliages déposés sur cette face pour réaliser la thermopile.

Par exemple et de manière non limitative, la granularité de la face sur laquelle la thermopile est déposée est comprise entre 600nm et 1,2µm.

Les deux métaux ou alliages Co1 et Co2 formant la thermopile sont représentés en hachures verticales et horizontales dans la Fig. 1. Les deux métaux ou alliages Co1 et Co2 sont déposés sur la face polie du premier substrat Ce1 dans une configuration dite plaquée dans laquelle le conducteur Co2 ayant la plus forte conductivité recouvre partiellement le conducteur Co1 ayant la plus faible conductivité électrique.

Bien entendu, la présente invention est applicable lorsque les deux conducteurs sont dans une configuration dite juxtaposée, c'est-à-dire lorsque les deux conducteurs se juxtaposent.

Il est à remarquer que les épaisseurs des conducteurs Co1 et Co2 représentés en Fig. 1 et en particulier leur rapport avec les épaisseurs des céramiques Ce1 et Ce2 et des cales Ca1 à Ca9 ne reflètent pas la réalité.

Dans un exemple de réalisation particulier, chaque substrat de céramique a une épaisseur de 1 mm, chaque cavité a une largeur de 1,5 mm et une profondeur de 0,7mm et chaque cale a une largeur de 0.5 mm et une profondeur de 0.7mm.

Le choix de la céramique comme substrat permet de réaliser un dispositif pour la mesure d'un flux thermique qui soit opérationnel à des températures de l'ordre de 1000 °C. De plus, la céramique utilisée selon la présente invention a un coefficient de dilatation compatible avec les métaux et/alliages formant la thermopile.

Par exemple, la céramique présente un coefficient de dilatation de 93. 10⁻⁷ m/ °C pour des températures de 25°C à 300°C et tend vers 125. 10⁻⁷ m/ °C pour 800°C environ. La conductivité thermique de la céramique est de 1,46 W/m.K entre 0°C et 600°C et varie de 1,35 à 1,5 W/m.K sur l'ensemble de sa plage d'application.

La **Fig. 2** représente le dispositif pour la mesure d'un flux thermique selon la présente invention ainsi que la déflexion du flux thermique obtenue selon la présente invention.

Selon la présente invention, les deux substrats Ce1 et Ce2 sont collés à l'aide d'une colle non conductrice électriquement.

La face supérieure du substrat Ce2 est la face qui collecte le flux thermique incident représenté par les flèches en haut de la Fig. 2.

Les cales Ca5 à Ca9 du second substrat Ce2 permettent d'obtenir une constriction des lignes de flux thermique au niveau des cales Ca5 à Ca9 dont les contacts inférieurs imposent à l'ensemble de la chaleur de transiter vers les thermojonctions chaudes Tj1, Tj3, Tj5, Tj7 à Tj9.

Les thermojonctions chaudes Tj1, Tj3, Tj5, Tj7 à Tj9 sont préférentiellement situées au dessous du milieu des cales Ca5 à Ca9.

Les cales Ca5 à Ca9 du second substrat Ce2 permettent d'obtenir une constriction des lignes de flux thermique au niveau des cales Ca1 à Ca4 dont les contacts inférieurs imposent à l'ensemble de la chaleur des thermojonctions chaudes Tj1, Tj3, Tj5, Tj7 et Tj9 de transiter vers les cales Ca1 à Ca4.

Cette duplication des cales pour les substrats en céramique Ce1 et Ce2 diminue la conductivité thermique du dispositif pour la mesure d'un flux thermique et améliore grandement la sensibilité du dispositif pour la mesure d'un flux thermique.

Les cales Ca1 à Ca4 du premier substrat Ce1 sont disposées sous une thermojonction Tj2, Tj4, Tj 6, Tj8 sur deux de la thermopile, les cales du second substrat Ca5 à Ca9 reposent sur une thermojonction Tj1, Tj3, Tj5, Tj7 et Tj9 sous laquelle une cale Ca1 à Ca4 du premier substrat Ce1 n'est pas disposée.

Dans la Fig. 2, la configuration dite plaquée n'est pas représentée par souci de simplification.

Il est à remarquer ici que la face inférieure du substrat Ce1 repose sur un puits thermique non représenté en Fig. 2.

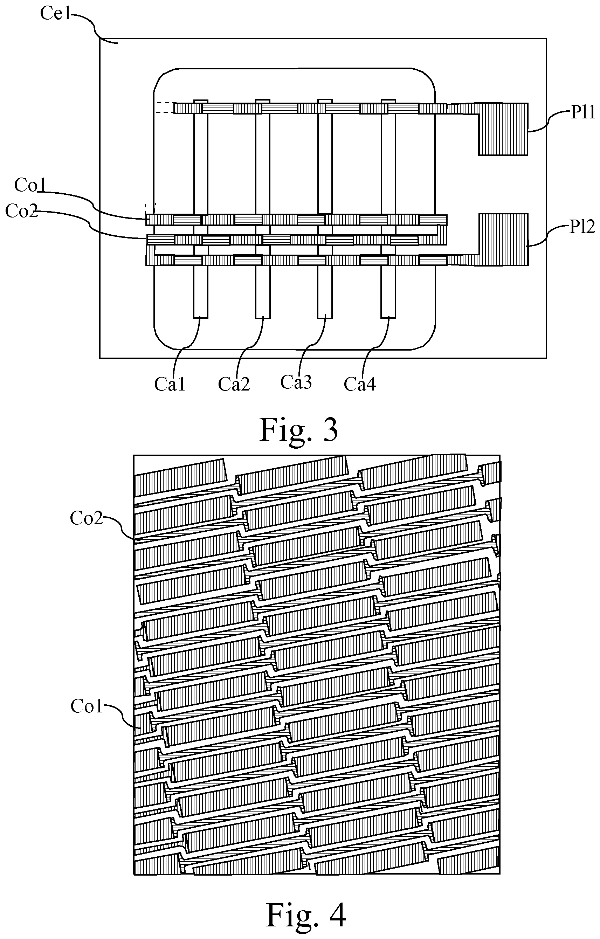

La **Fig. 3** représente une représentation schématique du premier substrat et de la thermopile.

La thermopile est constituée d'une bande continue composée alternativement de dépôts d'un premier et d'un second métaux ou alliages de caractéristiques thermoélectriques différentes. La bande continue est méandriforme et repliée pour former un quadrilatère. Chaque dépôt de métal ou d'alliage d'un méandre juxtapose un dépôt de métal ou d'alliage différent d'un autre méandre.

Ceci permet de réaliser les cales sous la forme de lignes.

Dans une variante de réalisation, chaque dépôt de métal ou d'alliage d'un méandre juxtapose un dépôt de métal ou d'alliage identique d'un autre méandre.

Selon cette variante de réalisation, les cales seront réalisées sous la forme d'un damier.

Les zones en hachures horizontales représentent les dépôts du métal ou de l'alliage le plus conducteur électriquement qui sont effectués sur une partie des dépôts du métal ou de l'alliage le moins conducteur électriquement.

Les zones en hachures verticales représentent les dépôts de métal ou d'alliage le moins conducteur électriquement.

Les bornes Pl1 et Pl2 sont des bornes sur lesquelles seront reliés des fils électriques permettant la mesure de la force électromotrice produite par la thermopile.

La **Fig. 4** est un mode particulier de la géométrie des dépôts de métaux ou d'alliages.

Selon le mode particulier de la Fig. 4, les dépôts du métal ou de l'alliage ayant la plus grande conductivité électrique sont effectués sur des dépôts du métal ou de l'alliage ayant la plus faible conductivité électrique.

Les dépôts du métal ou de l'alliage ayant la plus grande conductivité électrique et les dépôts du métal ou de l'alliage ayant la plus faible conductivité électrique sur lesquels sont effectués les dépôts du métal ou de l'alliage ayant la plus grande conductivité électrique représentés en hachures horizontales ont à leurs extrémités une largeur égale à la largeur des dépôts du métal ou de l'alliage, représentés en hachures verticales, ayant la plus faible conductivité électrique et sur lesquels aucun dépôt de métal ou de l'alliage ayant la plus grande conductivité électrique n'est effectué.

Les dépôts du métal ou de l'alliage ayant la plus grande conductivité électrique et les dépôts du métal ou de l'alliage ayant la plus faible conductivité électrique sur lesquels sont effectués les dépôts du métal ou de l'alliage ayant la plus grande conductivité électrique ont en leur partie intermédiaire une largeur inférieure à la largeur des dépôts du métal ou de l'alliage ayant la plus faible conductivité électrique et sur lesquels aucun dépôt de métal ou de l'alliage ayant la plus grande conductivité électrique n'est effectué.

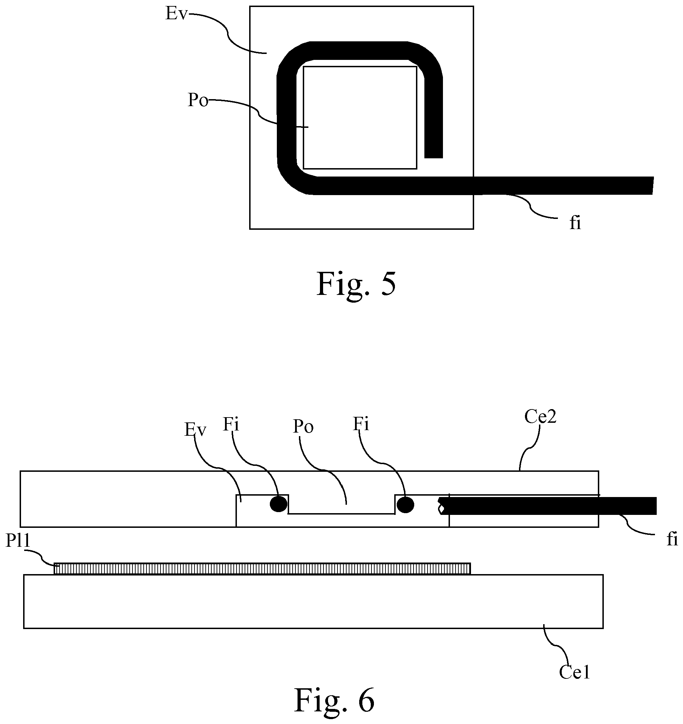

La **Fig. 5** est une vue schématique de l'usinage du second substrat dans chaque partie en regard avec une borne de contact de la thermopile ainsi que du placement du fil dans la partie usinée.

Le second substrat est usiné dans chaque partie en regard avec une borne de contact de manière à créer un évidement Ev autour d'un plot Po.

Le fil Fi est enroulé autour du plot Po disposé au centre de l'évidement.

Par exemple, le plot Po est un carré de 2 mm de côté.

L'évidement est effectué dans un carré de 4mm de côté sur une largeur de 1mm.

La **Fig. 6** est une coupe de l'usinage du second substrat dans une partie en regard avec une borne de contact de la thermopile ainsi que du placement du fil dans la partie usinée.

La thermopile déposée sur le substrat Ce1 comporte une première et une seconde bornes de contacts.

Dans l'exemple de la Fig. 6, la borne Pl1 est en regard avec l'évidement Ev dans lequel le fil Fi entourant le plot Po est placé.

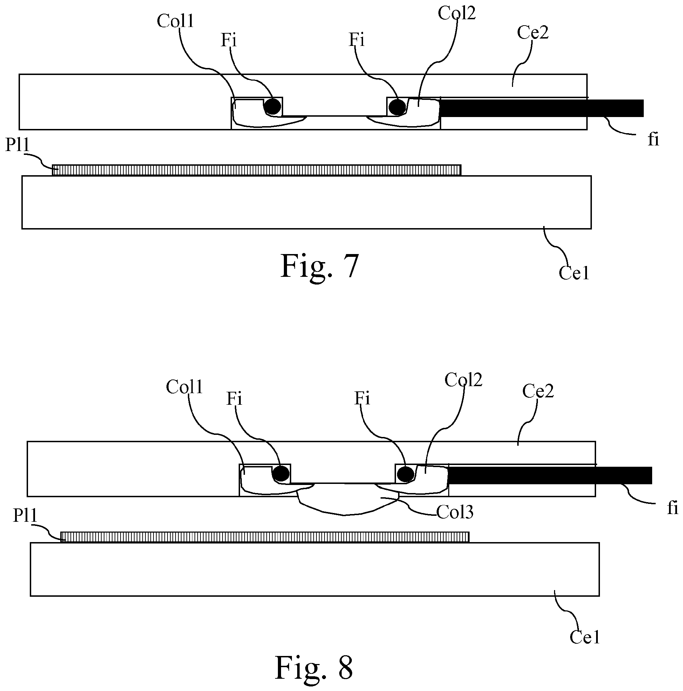

La **Fig. 7** est une coupe de l'usinage du second substrat dans une partie en regard avec une borne de contact de la thermopile ainsi que du collage du fil dans la partie usinée.

Dans un premier temps, le fil Fi est fixé au substrat Ce2 par l'intermédiaire d'une colle conductrice.

Les plots de colle conductrice sont notés Col1 et Col2 dans la Fig. 7.

Il est à remarquer que les plots de colle conductrice Col1 et Col2 ne doivent pas dépasser la surface non usinée du substrat Ce3 de manière à garantir que le collage des deux substrats soit effectué sur des surfaces planes.

La **Fig. 8** est une coupe de l'usinage du second substrat dans une partie en regard avec une borne de contact de la thermopile ainsi que de l'établissement de la liaison électrique entre le fil collé dans la partie usinée avec une borne de contact de la thermopile.

L'établissement de la liaison électrique entre le fil Fi et la borne de contact Pl1 est effectué en appliquant un point de colle conductrice électriquement Col3 sur les points de colle Col1 et Col2 à l'état solide et sur le plot Po.

Lors du collage des substrats Ce1 et Ce2, la liaison électrique entre le fil Fl et la borne Pl1 sera assurée par le point de colle Col3.

La manipulation et le placement des substrats Ce1 et Ce2 ne sont pas perturbés par les fils car ceux-ci sont fixés au substrat Ce2 par les points de colle Col1 et Col2.

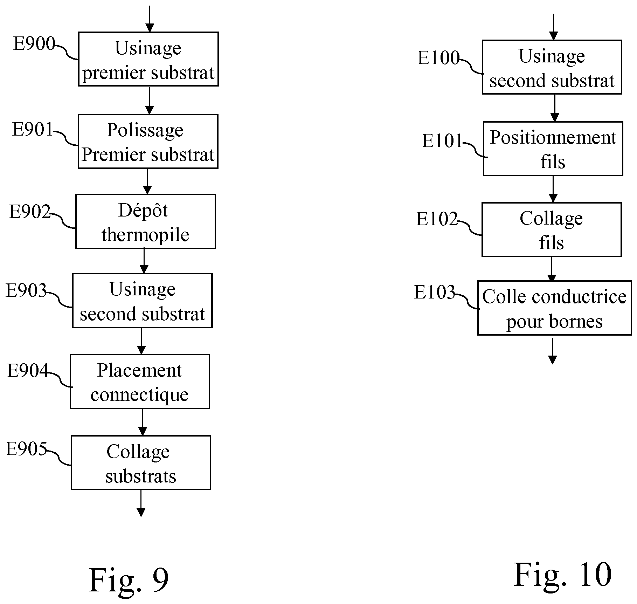

La **Fig. 9** est un exemple d'algorithme de fabrication d'un dispositif pour la mesure d'un flux thermique selon la présente invention.

A l'étape E900, le premier substrat Ce1 est fraisé sur une de ses faces, de manière à obtenir une face comportant des cavités séparées par des cales de céramique.

A l'étape E901, la face opposée à la face usinée du substrat Ce1 est polie si la granularité du substrat Ce1 n'est pas compatible avec le dépôt de la thermopile.

A l'étape E902, la thermopile est déposée sur la face polie par exemple selon un procédé de pulvérisation cathodique.

A l'étape E903, le second substrat Ce2 est fraisé sur une de ses faces de manière à obtenir une face comportant des cavités séparées par des cales de céramique.

A l'étape E904, la connectique permettant la mesure de la force électromotrice est placée. Cette étape sera décrite plus en détail en regard de la Fig. 10.

A l'étape E904, les deux substrats Ce1 et Ce2 sont collés à l'aide d'une colle non conductrice électriquement.

La face usinée du second substrat Ce2 est collée à la face du premier substrat sur laquelle la thermopile a été déposée.

La **Fig. 10** est un exemple d'algorithme de placement de connectique pour un dispositif pour la mesure d'un flux thermique selon la présente invention.

A l'étape E100, la face usinée du second substrat est usinée dans chaque partie en regard avec une borne de contact de manière à créer un évidement Ev autour d'un plot Po.

A l'étape E101, un fil est placé autour de chaque plot Pl dans l'évidement.

A l'étape E102, chaque fil est collé au second substrat à l'aide d'une colle conductrice électriquement.

A l'étape E103, un plot de colle conductrice électriquement est placé sur le plot Po et les plots de colle conductrice électriquement déposés à l'étape E102.

Bien entendu, la présente invention n'est nullement limitée aux modes de réalisation décrits ici, mais englobe, bien au contraire, toute variante à la portée de l'homme du métier et particulièrement la combinaison de différents modes de réalisation de la présente invention.

## Revendications

1. Dispositif pour la mesure d'un flux thermique, comportant une thermopile constituée d'une pluralité de thermojonctions (Tj1... 9) de type distribuées, **caractérisé en ce que** le dispositif est constitué d'un premier et un second substrats (Ce1, Ce2) en céramique, une première face du premier substrat (Ce1) est composée de cavités séparées par des cales (Ca1...4) de céramique, la thermopile est placée sur une seconde face plane du premier substrat opposée à la première face, les cales du premier substrat sont disposées sous une thermojonction (Tj2, 4, 6, 8) sur deux de la thermopile, une première face du second substrat (Ce2) est composée de cavités séparées par des cales (Ce5... 9) de céramique, une seconde face du second substrat étant plane, la première face du second substrat composée des cavités et des cales reposant sur les thermojonctions de telle sorte que les cales du second substrat reposent sur une thermojonction (Tj1, 3, 5, 7, 9) sous laquelle une cale du premier substrat n'est pas disposée.

2. Dispositif selon la revendication 1, **caractérisé en ce que** la céramique a une conductivité thermique comprise entre 0,5 à 15 W/m.K.

3. Dispositif selon la revendication 1 ou 2, **caractérisé en ce que** la céramique a une conductivité thermique de 1,46 W/m.K.

4. Dispositif selon l'une quelconque des revendications 1 à 3, **caractérisé en ce que** les cavités et les cales sont obtenues par usinage des substrats.

5. Dispositif selon l'une quelconque des revendications 1 à 4, **caractérisé en ce que** les premier et second substrats sont collés l'un à l'autre par l'intermédiaire des cales du second substrat, de la face du second substrat composée de cavités séparées par des cales de céramique, de la seconde face du premier substrat et de la thermopile.

6. Dispositif selon l'une quelconque des revendications 1 à 5, **caractérisé en ce que** la thermopile est constituée d'une bande continue composée alternativement de dépôts d'un premier et d'un second métaux ou alliages de caractéristiques thermoélectriques différentes, la bande continue est méandriforme et repliée pour former un quadrilatère et **en ce que** chaque dépôt de métal ou d'alliage d'un méandre juxtapose un dépôt de métal ou d'alliage différent d'un autre méandre.

7. Dispositif selon l'une quelconque des revendications 1 à 5, **caractérisé en ce que** les métaux ou alliages ont des conductivités électriques différentes, les dépôts du métal ou de l'alliage ayant la plus grande conductivité électrique sont effectués sur des dépôts du métal ou de l'alliage ayant la plus faible conductivité électrique, et **en ce que** les dépôts du métal ou de l'alliage ayant la plus grande conductivité électrique et les dépôts du métal ou de l'alliage ayant la plus faible conductivité électrique sur lesquels sont effectués les dépôts du métal ou de l'alliage ayant la plus grande conductivité électrique ont à leurs extrémités une largeur égale à la largeur des dépôts du métal ou de l'alliage ayant la plus faible conductivité électrique et sur lesquels aucun dépôt de métal ou de l'alliage ayant la plus grande conductivité électrique n'est effectué et ont en leur partie intermédiaire une largeur inférieure à la largeur des dépôts du métal ou de l'alliage ayant la plus faible conductivité électrique et sur lesquels aucun dépôt de métal ou de l'alliage ayant la plus grande conductivité électrique n'est effectué.

8. Dispositif selon l'une quelconque des revendications 1 à 5, **caractérisé en ce que** la thermopile comporte une première et une seconde bornes de contacts, chaque borne de contact étant apte à être reliée électriquement à un fil, et **en ce que** le second substrat est usiné dans chaque partie en regard avec une borne de contact de manière à permettre un enroulement du fil autour d'un plot disposé au centre de la partie usinée.

9. Procédé de fabrication d'un dispositif pour la mesure d'un flux thermique, comportant une thermopile constituée d'une pluralité de thermojonctions (Tj1...9)
de type distribuées, **caractérisé en ce que** le procédé comporte les étapes de :
- usinage d'un premier substrat (Ce1) de céramique sur une face pour obtenir des cavités séparées par des cales (Ca1... 4) de céramique,
- dépôt de la thermopile sur la seconde face plane du premier substrat, les cales du premier substrat étant disposées sous une thermojonction (Tj2, 4, 6, 8) sur deux de la thermopile,
- usinage d'un second substrat (Ce2) de céramique sur une face pour obtenir des cavités séparées par des cales (Ce5...9) de céramique,
- collage de la face usinée du second substrat sur la face du premier substrat comportant la thermopile de telle manière que les cales du second substrat reposent sur une thermojonction (Tj1, 3, 5, 7, 9) sous laquelle une cale du premier substrat n'est pas disposée.

10. Procédé selon la revendication 9, **caractérisé en ce que** le procédé comporte en outre une étape de polissage de la seconde face plane du premier substrat préalablement au dépôt de la thermopile.

11. Procédé selon la revendication 9 ou 10, **caractérisé en ce que** la thermopile comporte une première et une seconde bornes de contacts, chaque borne de contact étant apte à être reliée électriquement à un fil, et **en ce que** le procédé comporte en outre l'étape d'usinage du second substrat dans chaque partie en regard avec une borne de contact de manière à permettre un enroulement du fil autour d'un plot disposé au centre de la partie usinée.

12. Procédé selon la revendication 11, **caractérisé en ce que** le procédé comporte en outre les étapes de :
- enroulement de chaque fil autour du plot,
- collage de chaque fil au second substrat à l'aide d'une colle conductrice,
- établissement d'une liaison électrique entre chaque fil collé et une borne de contact à l'aide d'une colle conductrice.

## Patentansprüche

1. Vorrichtung zum Messen eins Wärmestroms, umfassend einen Thermopile, der von einer Vielzahl von Thermoverbindungen gebildet (Tj1 ... 9) vom verteilten Typ gebildet ist, **dadurch gekennzeichnet, dass** die Vorrichtung von einem ersten und einem zweiten Substrat (Ce1, Ce2) aus Keramik gebildet ist, wobei eine erste Seite des ersten Substrats (Ce1) aus Hohlräumen besteht, die durch Keile (Cal ... 4) aus Keramik getrennt sind, wobei der Thermopile auf einer zweiten ebenen Fläche des ersten Substrats gegenüber der ersten Fläche angeordnet ist, wobei die Keile des ersten Substrats unter jeder zweiten Thermoverbindung (Tj2, 4, 6, 8) des Thermopiles angeordnet sind, wobei eine erste Fläche des zweiten Substrats (Ce2) aus Hohlräumen besteht, die durch Keile (Ce5 ... 9) aus Keramik getrennt sind, wobei die zweite Fläche des zweiten Substrats eben ist, wobei die erste Fläche des zweiten Substrats, die aus Hohlräumen und Keilen besteht, auf Thermoverbindungen aufliegt, so dass die Keile des zweiten Substrats auf einer Thermoverbindung (Tj1, 3, 5, 7, 9) aufliegen, unter der ein Keil des ersten Substrats nicht angeordnet ist.

2. Vorrichtung nach Anspruch 1, **dadurch gekennzeichnet, dass** die Keramik eine Wärmeleitfähigkeit zwischen 0,5 und 15 W/m.K hat.

3. Vorrichtung nach Anspruch 1 oder 2, **dadurch gekennzeichnet, dass** die Keramik eine Wärmeleitfähigkeit von 1,46 W/m.K hat.

4. Vorrichtung nach einem der Ansprüche 1 bis 3, **dadurch gekennzeichnet, dass** die Hohlräume und die Keile durch Bearbeitung der Substrate erhalten werden.

5. Vorrichtung nach einem der Ansprüche 1 bis 4, **dadurch gekennzeichnet, dass** die ersten und zweiten Substrate mit Hilfe der Keile des zweiten Substrats, der Fläche des zweiten Substrats, die aus durch Keramikkeile getrennten Hohlräumen besteht, der zweiten Fläche des ersten Substrats und des Thermpiles aneinander geklebt sind.

6. Vorrichtung nach einem der Ansprüche 1 bis 5, **dadurch gekennzeichnet, dass** der Thermopile aus einem kontinuierlichen Band besteht, das alternativ aus Schichten von ersten und zweiten Metallen oder Legierungen mit unterschiedlichen thermoelektrischen Eigenschaften gebildet ist, wobei das kontinuierliche Band mäanderförmig und umgebogen ist, um ein Viereck zu bilden, und dass jede Schicht aus Metall oder einer Legierung eines Mäanders neben einer unterschiedlichen Schicht eines Metalls oder einer Legierung eines anderen Mäanders angeordnet ist.

7. Vorrichtung nach einem der Ansprüche 1 bis 5, **dadurch gekennzeichnet, dass** die Metalle oder Legierungen unterschiedliche elektrische Leitfähigkeiten haben, wobei die Schichten des Metalls oder der Legierung, die die größte elektrische Leitfähigkeit haben, auf Schichten des Metalls oder der Legierung, die die geringste elektrische Leitfähigkeit haben, ausgeführt sind, und dass die Schichten des Metalls oder der Legierung mit der größten elektrischen Leitfähigkeit und die Schichten des Metalls oder der Legierung mit der geringsten elektrischen Leitfähigkeit, auf denen die Schichten des Metalls oder der Legierung mit der größten elektrischen Leitfähigkeit ausgeführt sind, an ihren Enden einer Breite gleich der Breite der Schichten des Metalls oder der Legierung mit der geringsten elektrischen Leitfähigkeit haben, und auf denen keine Schicht eines Metalls oder der Legierung mit der größten elektrischen Leitfähigkeit ausgeführt ist, und in ihrem Zwischenteil eine geringere Breite als die Breite der Schichten des Metalls oder der Legierung mit der geringsten elektrischen Leitfähigkeit haben, und auf denen keine Schicht eines Metalls oder der Legierung mit der größten elektrischen Leitfähigkeit ausgeführt ist.

8. Vorrichtung nach einem der Ansprüche 1 bis 5, **dadurch gekennzeichnet, dass** der Thermopile eine erste und eine zweite Kontaktklemme umfasst, wobei jede Kontaktklemme geeignet ist, elektrisch mit einem Draht verbunden zu werden, und dass das zweite Substrat in jedem Teil gegenüber einer Kontaktklemme bearbeitet ist, um ein Wickeln des Drahtes um einen in der Mitte des bearbeiteten Teils befindlichen Stift zu ermöglichen.

9. Verfahren zur Herstellung einer Vorrichtung zum Messen eins Wärmestroms, umfassend einen Thermopile, der von einer Vielzahl von Thermoverbindungen gebildet (Tjl ... 9) vom verteilten Typ gebildet ist, **dadurch gekennzeichnet, dass** das Verfahren die folgenden Schritte umfasst:
- Bearbeiten eines ersten Substrats (Ce1) aus Keramik auf einer Fläche, um durch Keile (Cal ... 4) aus Keramik getrennte Hohlräume zu erhalten,
- Aufbringen des Thermopiles auf die zweite ebene Fläche des ersten Substrats, wobei die Keile des ersten Substrats jeder zweiten Thermoverbindung (Tj2, 4, 6, 8) des Thermopiles angeordnet sind,
- Bearbeiten eines zweiten Substrats (Ce2) aus Keramik auf einer Fläche, um durch Keile (Ce5 ... 9) aus Keramik getrennte Hohlräume zu erhalten,
- Kleben der bearbeiteten Fläche des zweiten Substrats auf die Fläche des ersten Substrats, umfassend den Thermopile, so dass die Keile des zweiten Substrats auf einer Thermoverbindung (Tj1, 3, 5, 7, 9), unter der ein Keil des ersten Substrats nicht angeordnet ist, aufliegen.

10. Verfahren nach Anspruch 9, **dadurch gekennzeichnet, dass** das Verfahren ferner einen Schritt des Polierens der zweiten ebenen Fläche des ersten Substrats vor dem Aufbringend es Thermopiles umfasst.

11. Verfahren nach Anspruch 9 oder 10, **dadurch gekennzeichnet, dass** der Thermopile eine erste und eine zweite Kontaktklemme umfasst, wobei jede Kontaktklemme geeignet ist, elektrisch mit einem Draht verbunden zu werden, und dass das Verfahren ferner den Schritt einer Bearbeitung des zweiten Substrats in jedem Teil gegenüber einer Kontaktklemme umfasst, um ein Wickeln des Drahtes um einen in der Mitte des bearbeiteten Teils angeordneten Stift zu ermöglichen.

12. Verfahren nach Anspruch 11, **dadurch gekennzeichnet, dass** das Verfahren ferner die folgenden Schritte umfasst:
- Wickeln jedes Drahtes um den Stift,
- Kleben jedes Drahtes an das zweite Substrat mit Hilfe eines leitenden Klebstoffs,
- Herstellen einer elektrischen Verbindung zwischen jedem angeklebten Draht und einer Kontaktklemme mit Hilfe eines leitenden Klebstoffs.

## Claims

1. A device for measuring a heat flux, comprising a thermopile formed of a plurality of thermojunctions (Tj1...9) of distributed type, **characterised in that** the device is formed of a first and a second ceramic substrate (Ce1, Ce2), a first face of the first substrate (Ce1 is composed of cavities which are separated by ceramic spacers (Ca1...Ca4, the thermopile is placed on a second planar face of the first substrate which is located opposite the first face, the spacers of the first substrate are arranged beneath one thermojunction (Tj2, 4, 6, 8)in two of the thermopile, a first face of the second substrate (Ce2)is composed of cavities which are separated by ceramic spacers (Ce5...9), a second face of the second substrate being planar, the first face of the second substrate composed of cavities and spacers rest on a thermojunctions such as the spacers of the second substrate rest on z thermojunction (Tj 1, 3, 5, 7, 9) beneath which a spacer of the first substrate is not arranged.

2. A device according to Claim 1, **characterised in that** the ceramic has a thermal conductivity of between 0.5 and 15 W/m.K.

3. A device according to Claim 1 or 2, **characterised in that** the ceramic has a thermal conductivity of 1.46 W/m.K.

4. A device according to any one of Claims 1 to 3, **characterised in that** the cavities and the spacers are obtained by machining the substrates.

5. A device according to any one of Claims 1 to 4, **characterised in that** the first and second substrates are glued to one another by means of the spacers of the second substrate, the face of the second substrate which is composed of cavities which are separated by ceramic spacers from the second face of the first substrate, and the thermopile.

6. A device according to any one of Claims 1 to 5, **characterised in that** the thermopile is formed of a continuous strip composed alternatively of deposits of a first and a second metal or alloy of different thermoelectric properties, the continuous strip is meandering and folded to form a quadrilateral, and **in that** each deposit of metal or alloy of a meander is juxtaposed with a different deposit of metal or alloy of another meander.

7. A device according to any one of Claims 1 to 5, **characterised in that** the metals or alloys have different electrical conductivities, the deposits of the metal or the alloy having the greater electrical conductivity are carried out on deposits of the metal or the alloy having the lesser electrical conductivity, and **in that** the deposits of the metal or the alloy having the greater electrical conductivity and the deposits of the metal or the alloy having the lesser electrical conductivity on which the deposits of the metal or the alloy having the greater electrical conductivity are carried out have at their ends a width equal to the width of the deposits of the metal or the alloy having the lesser electrical conductivity and on which no deposit of metal or the alloy having the greater electrical conductivity is carried out, and have in their intermediate part a width which is less than the width of the deposits of the metal or the alloy having the lesser electrical conductivity and on which no deposit of metal or the alloy having the greater electrical conductivity is carried out.

8. A device according to any one of Claims 1 to 5, **characterised in that** the thermopile comprises a first and a second contact terminal, each contact terminal being capable of being electrically connected to a wire, and **in that** the second substrate is machined in each part facing a contact terminal so as to permit winding of the wire around a block arranged in the centre of the machined part.

9. A method for manufacturing a device for measuring a heat flux, comprising a thermopile formed of a plurality of thermojunctions (Tj1...9) of distributed type, **characterised in that** the method comprises the steps of:
- machining a first ceramic substrate (Ce1)on one face in order to obtain cavities which are separated by ceramic spacers (Ca1...4),
- depositing the thermopile on the second planar face of the first substrate, the spacers of the first substrate being arranged beneath one thermojunction (Tj2, 4, 6, 8)in two of the thermopile,
- machining a second ceramic substrate (Ce2)on one face in order to obtain cavities which are separated by ceramic spacers (Ce5...9,
- gluing the machined face of the second substrate onto the face of the first substrate comprising the thermopile such that the spacers of the second substrate rest on a thermojunction (Tj1, 3, 5, 7, 9)beneath which a spacer of the first substrate is not arranged.

10. A method according to Claim 9, **characterised in that** the method furthermore comprises a step of polishing the second planar face of the first substrate prior to the depositing of the thermopile.

11. A method according to Claim 9 or 10, **characterised in that** the thermopile comprises a first and a second contact terminal, each contact terminal being capable of being electrically connected to a wire, and **in that** the method furthermore comprises the step of machining the second substrate in each part facing a contact terminal so as to permit winding of the wire around a block arranged in the centre of the machined part.

12. A method according to Claim 11, **characterised in that** the method furthermore comprises the steps of:
- winding each wire around the block,
- gluing each wire to the second substrate using a conductive glue,
- establishing an electrical connection between each glued wire and a contact terminal using a conductive glue.
